# EUROPEAN PATENT SPECIFICATION

(11) **EP 0 599 505 B1**
(45) Date of publication and mention of the grant of the patent: **14.04.1999**
(21) Application number: 93308796.7
(22) Date of filing: 03.11.1993
(51) Int. Cl.: H03B 5/12

(54) **Tunable resonance circuit for a voltage controlled oscillator**
Abstimmbarer Resonanzkreis für spannungsgesteuerten Oszillator
Circuit résonateur accordable pour un oscillateur commandé par tension

(30) Priority: 27.11.1992 FI 925405
(43) Date of publication of application: 01.06.1994
(73) Proprietor: NOKIA MOBILE PHONES LTD., 24101 Salo (FI)
(72) Inventor: Liukkonen, Jorma, FIN-27280 Salo (FI)
(74) Representative: Frain, Timothy John

(56) References cited:
- EP-A- 0 207 650
- EP-A- 0 270 298
- EP-A- 0 479 599
- WO-A-87/04304
- US-A- 5 105 162

## Description

The present invention relates to a tunable resonance circuit for a voltage controlled oscillator (VCO) in a digital radio telephone, in particular to a VCO having an oscillation frequency controlled by varying a voltage across a voltage dependent capacitance disposed in the resonance circuit of the VCO.

A VCO is an oscillation circuit having an output frequency which varies in response to a control voltage applied to the circuit. Typically, a VCO is used as one of the components of a Phase-Locked Loop (PLL). A phase-locked loop is frequently used when two signals have to be synchronized in both phase and frequency. The output signal of the VCO is locked to both the frequency and phase of a reference signal, whereby, the output signal of the VCO tracks the changes of the reference signal. In the loop phase comparator the output signal of the loop or the signal obtained by dividing therefrom is compared with the reference signal. The phase difference of the signals is converted, using the phase comparator and the filter, into a correction voltage, which is coupled as a control voltage to the voltage controlled oscillator.

The control voltage raises or lowers the frequency of the oscillator so that the loop becomes locked. While in a locked state, no signals are emitted from the phase comparator and the control voltage of the VCO generated by the loop filter remains constant in value. The angular coefficient of a characteristic representing the dependence of the frequency of the VCO on the control voltage is called the VCO coefficient. As a general rule, it can be stated that the higher the VCO coefficient the greater are the noise problems of the loop, and the harder it is to provide frequency or spectral purity.

The voltage controlled oscillator can be implemented in a variety of ways. Ordinarily, it comprises a transistor connected as an oscillator. The internal capacitance of the transistor may act as the feedback loop which maintains oscillation of the transistor. Use of a bipolar transistor may extend the oscillation frequency from 1 GHz to 10 GHz, and with FETs, even higher frequencies can be obtained. For controlling the oscillation and for the circuit to serve as a voltage controlled oscillator VCO, a series resonance circuit is disposed in the circuit of an electrode of the oscillator transistor. This can be constructed in a number of ways to obtain the desired properties, but in principle it consists of a capacitance diode, an inductance, e.g. a strip line with one end usually being shortcircuited, and of the internal capacitance of the transistor. Typically the capacitance diode is connected in series with the strip line, or in parallel thereto so that the anode of the diode can be D.C. grounded. By coupling the control direct voltage (or other external control voltage) produced by the loop filter of the PLL to the cathode of the capacitance diode, the voltage across the capacitance diode changes correspondingly changing the capacitance of the diode. Thus, the entire capacitance of the oscillation circuit changes respectively, as a result of which the amplified oscillation signal frequency derived from the transistor changes to conform to the control voltage.

When a phase-locked loop (PLL) is used in the frequency synthesizer of a multiple-channel radio phone, the requirements set for the VCO are very high. A typical multichannel radio phone is a phone of a modern cellular system in which a wide frequency range must be produced utilising a frequency synthesizer. Particularly in digital systems, the synthesizer is required to possess the ability to rapidly shift frequency and to have a wide frequency range. Since the control voltage of the VCO may have values in the range 0V ... Vcc, where Vcc is the operating voltage of the phone, and the frequency range required of the VCO is wide, it means a rather large VCO coefficient. In the present GSM system the frequency range requirement is of the order 25 MHz if both the transmission and reception are provided with synthesizers of their own, and 70 MHz, if only one synthesizer is used. Equally, a frequency range produced e.g. in DCS1800 system is 75 MHz with two synthesizers, but 170 MHz with one synthesizer. Producing such a wide frequency range using one synthesizer only requires the use of an extremely high VCO coefficient which inevitably leads to problems due to the correspondingly increased noise and interference sensitivity.

In digital telephone systems the synthesizer is also required to have a very rapid ability to shift frequency. The settling time after large frequency jumps should also be short.

It is known in the state of art to expand the frequency range of the VCO by changing the components of the resonance circuit. The changes can be done, for instance, by adding more capacitance or inductance to the resonance circuit using e.g. a PIN diode switch. It is also possible to use two resonance circuits which can be switchably connected. A drawback of such systems is the increased power consumption of the device and production of additional resonances due to the extra components. Moreover, the switches and organization of the control thereof complicate the structure of the VCO.

It is also possible to arrange for the control voltage obtained from the loop filter to be coupled through a voltage doubler to the VCO, whereby two frequency ranges can be produced from the VCO depending on whether the voltage is doubled or not. Such a procedure requires the use of a controllable switch, Additionally, the response speed of the loop to a frequency change is not increased. The speed will not be increased because of the narrowbandedness of the loop filter resulting in it taking a given time before the control voltage corresponding to the new frequency will be seen at the output of the filter.

The capacitance diode can be a varactor. Such a varactor included in the resonance circuit has a non-linear voltage / capacitance characteristic curve, the linear control range of the VCO is without any linearization measures limited. Therefore, the arrangements for overcoming the nonlinearity of the varactor also increase the linear control range of the VCO. In order to enhance the linearity, e.g. a negative bias voltage can be used on the varactor, whereby endeavours are made to shift the operation to the linear portion of its characteristic curve.

When a VCO is used as a component for the phase-locked loop, the settling of the loop can be accelerated utilising various accelerating couplings known in the art, such as changing of the loop filter into a wide-banded one for the time of the channel switch, or by injecting a direct voltage into the control voltage line of the VCO for the time of the channel switch. A drawback of the injecting is how to arrange a voltage of precisely the right magnitude and equivalent to a given frequency into the control voltage. Now, ROM memory can be used in digital loops in which the frequency / control voltage values have been tabulated and wherefrom a given value is taken through the DA converter to the control voltage line.

International patent application WO 87/04304 discloses a tunable resonance circuit for a voltage controlled oscillator comprising a voltage controlled capacitance electrically coupled to an inductor, wherein a terminal of the voltage controlled capacitance is selectably electrically connectable to a first voltage and a second voltage respectively, at least one of the voltages being a negative voltage. The multi-level biassing system has a complex switching arrangement. European patent application EP 0 207 650 discloses a tuning circuit for a varactor utilising transmission line inductances.

The foregoing problems and drawbacks are addressed by the following invention which is defined in claim 1.

This has the advantage that it requires very few extra components and does not introduce extra noise into the system.

In a preferred embodiment of the invention the tunable resonance circuit in the digital radio telephone is disposed in a VCO comprising an oscillator means electrically coupled to the varactor and operable to oscillate in accordance with the tunable resonance circuit, and a control voltage electrically coupled to a cathode of the varactor, wherein the frequency of oscillation of the oscillation means is selectable to lie in a first frequency range and a second frequency range respectively corresponding to the first and second voltages. This has the advantage that the VCO coefficient is not unduly enlarged, and thus the VCO interference sensitivity is not increased. Furthermore, the VCO can now have improved loop acceleration to facilitate quick changes in frequency.

A suitable application for the VCO is as part of a frequency synthesizer. In particular, the frequency synthesiser can be adapted to connect the anode of the varactor to the negative voltage substantially contemporaneously with a frequency channel control signal changing the division number of the frequency divider in the frequency synthesizer. This results in a substantially large frequency jump and reduced settling period.

In accordance with the invention, either a negative direct voltage -V_{b} is arranged by means of a controllable switch to the anode of the capacitance diode included in the resonance circuit or, with regard to the direct current, it is connected to the ground of the circuit, whereby the anode has a direct voltage 0 V. On the other hand, when in the cathode of said capacitance diode the external control direct voltage V_{cntrl} of the VCO is effective, having a given variation range from 0 to V_{cntrl,MAX}, the voltage range across the capacitance diode is either 0 to V_{cntrl,MAX} if in the anode the 0 V direct voltage is effective, or it is V_{b} to (V_{cntrl,MAX}+V_{b}) when the anode has a negative voltage -V_{b}. This means that, depending on the anode voltage of the diode, two voltage control ranges can be provided for the VCO, and consequently, two frequency ranges although the external control voltage only changes within one range. It is preferable to arrange the frequency ranges to be partly overlapping.

The invention is described more specifically with the aid of the accompanying figures, in which:-
- Fig. 1: presents the principle circuit of a phase-locked loop,
- Fig. 2: presents a voltage-controlled oscillator provided with a circuit according to the invention, and
- Fig. 3: illustrates the output voltage of the oscillator as a function of the control voltage.

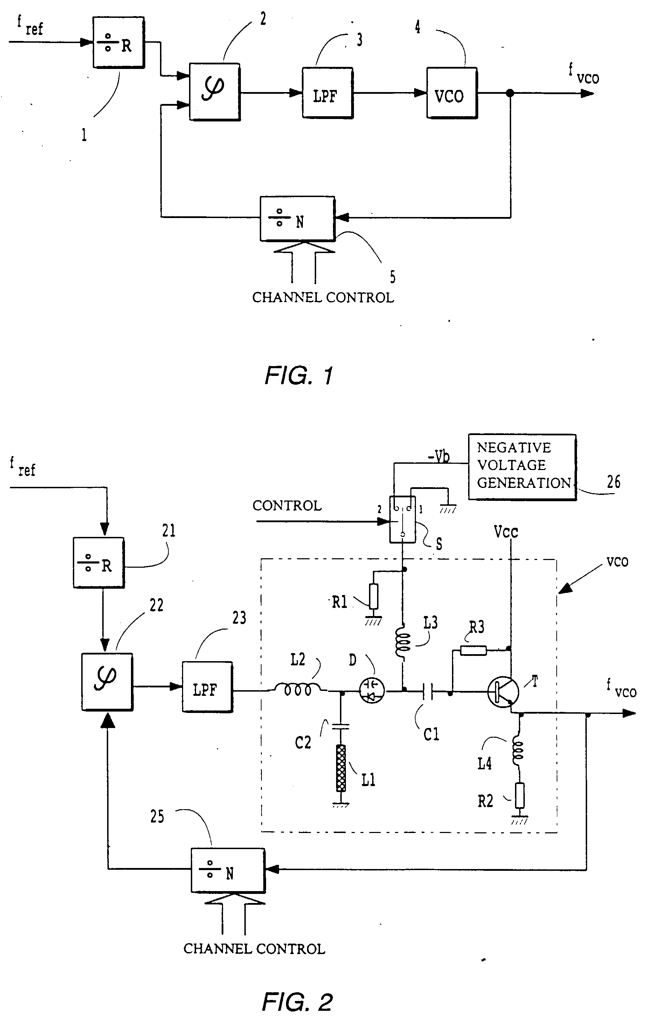

The phase-locked loop presented in Fig. 1 is used in a radio phone frequency synthesizer. A reference frequency f_{ref} divided by R in the reference divider and a frequency from the output frequency f_{VCO} of a voltage controlled oscillator VCO, divided by N in a loop divider 5, enter a phase comparator 2. A signal corresponding to the phase difference of said frequencies is coupled via a narrow-banded low pass filter 3 into the control voltage of VCO 4. The voltage changes the output voltage of the VCO, whereby, when the loop is in equilibrium, f_{VCO} = N/R ∗ f_{ref} is valid. Various output frequencies can be produced by supplying new dividing numerals N into the loop divider 5, whereby the synthesizer is each time tuned to a given radio channel by a given numeral N. In applications requiring a great stability, the reference frequency is produced by means of a voltage-controlled, temperature compensated crystal oscillator.

As presented in the preceding description of the state of art, the structure of the VCO 4 may vary greatly in the component level, even though certain basic details remain unchanged. Because of the structure, it is always provided with a given frequency range ΔV equivalent to a given control voltage range ΔV_{cntrl}.

Fig. 2 presents a circuit according to the invention for enlarging the voltage range of the VCO. The basic structure of the VCO described above is merely one of several potential ones, and it is introduced for the better understanding of the invention. The VCO described here comprises a transistor T, a capacitance diode D, and a strip line L1. The emitter of the transistor is grounded through inductance L4 and resistance R2. They, similarly as the feedback resistor R3, set the operating point of the transistor. The capacitors C2 and C1 serve as DC separation capacitors. The inductance L2 prevents the access of the oscillation frequency signal into the loop filter. The circuit oscillates at a frequency determined by the inductance of the strip line L1 and the capacitance of the capacitance diode D, and the internal capacitance of the transistor T. The control voltage V_{cntrl} derived from the loop filter 23 is carried to the cathode of the capacitance diode, whereby said voltage affecting across said diode determines the capacitance value thereof, and consequently, the output frequency f_{VCO} of VCO. The control voltage V_{cntrl} may have values in the range 0 V to V_{cntrl,MAX}. In the exemplary case, V_{cntrl,MAX} = V_{cc}, where V_{cc} is the operating voltage of the circuit.

In accordance with the invention, to the anode side of the capacitance diode one of the two different voltage values can be passed by external control. One of the values, obtained when the switch S is in position 1, is 0 V, and the other value, obtained when the position of the switch is in position 2, is the negative voltage -V_{b}. According to an external control, obtained e.g. from the logic part of the phone, the switch S is in either position switching one of said voltages to the anode of diode D. The entry of a signal at oscillation frequency in the direction of switch S is prevented by inductance L3.

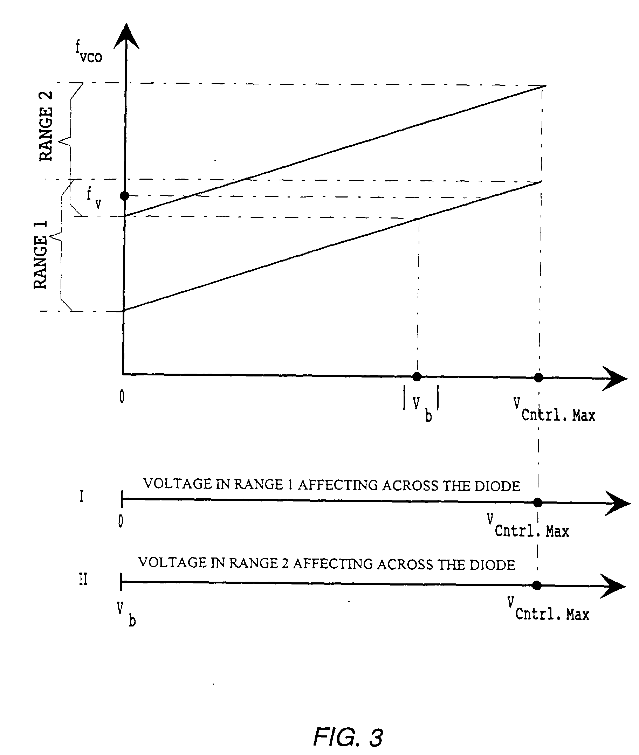

Next, reference is made to Fig. 3 demonstrating the dependence of the output frequency of the VCO on the control voltage V_{cntrl} obtained from the loop filter. When the switch is in position 1, it grounds, when viewed from the point of view of direct current, the anode of the capacitance diode. As a result thereof, the voltage affecting across the diode may vary within the range 0 V to V_{cntrl,MAX} (segment of line I) when the control voltage V_{cntrl} varies within the range 0 V to V_{cntrl,MAX}. Hereby, the output voltage f_{VCO} of the VCO may vary within the range RANGE 1.

With switch S in position 2, a negative voltage -V_{b} enters the anode of the capacitance diode. As a consequence thereof, the voltage, being effective across the diode, may now vary in the range V_{b} to V_{b}+V_{cntrl,MAX} (segment of line II) when the control voltage V_{cntrl} varies within the range 0 V to V_{cntrl,MAX}. Now, the output frequency f_{VCO} of the VCO may vary within the range RANGE 2.

The frequency ranges RANGE 1 and RANGE 2 overlap partly if the absolute value of the negative voltage is smaller than the maximum value of the control value. In radio phone use, the frequency ranges are so dimensioned that RANGE 1 covers a given part, e.g. half of the frequency range required of the synthesizer, and RANGE 2 covers the rest thereof. The frequency fᵥ shown in Fig. 3 is a freely selectable frequency in which the mode of operation is changed by shifting the position of the switch. This is controlled by the control part of the phone. In practice it is preferable to keep the frequency range overlapping because of the component distributions and temperature variations.

The circuit disclosed above is also appropriate for accelerating the settling of the synthesizer into the channel in the radio phone. In digital TDMA mobile phone systems, the frequency jump required between the transmission and reception time intervals may be great and the settling time requirement of the synthesizer may simultaneously be strict. When the frequency jump is sufficient, and for that reason, great speed is particularly required, the position of the switch is changed in conjunction with the channel switch. Hereby the VCO is provided with a control voltage, although the control voltage corresponding to the new frequency is not yet observable in the output of the loop filter. In this manner, the operation of the PLL can be clearly accelerated. At the moment of the switch of a channel the loop is not locked so that a change of the resonance frequency caused by a voltage change is immediately observable in the form of a change in the loop output frequency. With a frequency jump from a high frequency to a smaller one, the switch S is shifted from position 2 to position 1, respectively, with a jump from a lower frequency to a higher frequency, the switch is shifted from position 1 to position 2.

The circuit described above enables the provision of a small VCO coefficient although the frequency range is extremely wide. This means smaller noise in the output signal. By changing the biassing of the capacitance diode, the resonance circuit can be maintained simple in spite of the use of a switch. An additional advantage is also a chance of using the circuit in accelerating the channel switch. The negative voltage to be connected must be well filtered and temperature-stable in order to avoid any interferences. It can be taken from an approriate source, and in a phone a negative voltage can be provided e.g. from a display controller. It is also possible to produce a plurality of negative voltage values, among which the desired voltage value is connected to the anode of the capacitance diode. Hereby, several frequency ranges of the VCO can be obtained. In conjunction with a digital application, a DA converter can be used for producing a voltage. The above circuit will not increase the power consumption of the phone, which is important especially in hand phones.

Any VCO circuit known in the art can be so modified that a selectable voltage value is carried to the anode of the diode. More than two of such voltage values may be provided, whereby several frequency ranges can be produced.

In view of the foregoing description it will be evident to a person skilled in the art that various modifications may be made within the scope of the invention, which is defined by the claims.

## Claims

1. A digital radio telephone comprising a tunable resonance circuit for a voltage controlled oscillator (VCO) the tunable resonance circuit comprising
a voltage controlled capacitance (D) electrically coupled to an inductor (L1), wherein
a terminal of the voltage controlled capacitance (D) is selectably electrically connectable to a first voltage and a second voltage respectively whereby one of the voltages is a negative voltage provided from a display controller of the digital radio telephone.

2. A digital radio telephone according to claim 1 wherein the first voltage is ground and the second voltage is the negative voltage (-V_{b}) provided from the display controller.

3. A digital radio telephone according to claim 1 or 2 wherein the voltage controlled capacitance comprises a varactor having an anode thereof alternately electrically connectable to the first and second voltage.

4. A digital radio telephone according to claim 3, and further comprising an oscillator means electrically coupled to the varactor and operable to oscillate in accordance with the tunable resonance circuit, and a control voltage electrically coupled to a cathode of the varactor, wherein the frequency of oscillation of the oscillation means is selectable to lie in a first frequency range and a second frequency range respectively corresponding to the first and second voltages.

5. A digital radio telephone according to claim 4, wherein the first and second voltage are selected by a switch (S), having an output connected to the anode of the varactor (D) and a first input(1) connected to the ground of the circuit and another input(2) connected to a negative voltage provided from the display controller.

6. A digital radio telephone according to claim 5, wherein the switch (S) comprises a plurality of inputs, connected to respective negative voltages.

7. A digital radio telephone according to any of claims 4 to 6 having a frequency synthesizer comprising a voltage controlled oscillator a phase-locked loop and a phase-comparator (22) having a reference frequency signal (f_{ref}) coupled to a first input thereof and an output frequency (fvco) from the VCO coupled to a second input thereof, the comparator producing a signal comparable with the phase difference between the signals coupled to the first and second input, a low-pass filter (23) connected to the output of the phase comparator for filtering the output signal thereof into control direct voltage (V_{cntr1}), and a frequency divider (25), having a division number (N) controllable by a channel control signal for producing a divided signal from the output frequency of the VCO (f_{vco}).

8. A digital radio telephone according to claim 7, adapted to connect to the anode of the varactor (D) the negative voltage (-V_{b}) substantially contemporaneously with the channel control signal changing the division number (N) of the frequency divider (25) to result in a large frequency jump.

9. A digital radio telephone according to claim 8, wherein the frequency synthesizer is adapted by means of a processor for controlling the synthesizer.

10. A digital radio telephone according to any of claims 5 to 6, wherein the oscillator means comprises a transistor T.

## Patentansprüche

1. Digitales Funktelefon mit einem abstimmbaren Resonanzkreis für einen spannungsgesteuerten Oszillator (VCO), wobei der abstimmbare Resonanzkreis eine mit einem Induktor (L1) elektrisch gekoppelte spannungsgesteuerte Kapazität (D) enthält, ein Anschluß der spannungsgesteuerten Kapazität (D) wahlweise jeweils mit einer ersten Spannung und einer zweiten Spannung elektrisch verbindbar ist, und wobei eine der Spannungen eine von einer Anzeigensteuerung des digitalen Funktelefons zur Verfügung gestellte negative Spannung ist.

2. Digitales Funktelefon nach Anspruch 1, bei dem die erste Spannung Masse und die zweite Spannung die von der Anzeigensteuerung zur Verfügung gestellte negative Spannung (-V_{b}) ist.

3. Digitales Funktelefon nach Anspruch 1 oder 2, bei dem die spannungsgesteuerte Kapazität eine Varaktordiode mit einer Anode enthält, die alternativ mit der ersten und der zweiten Spannung elektrisch verbindbar ist.

4. Digitales Funktelefon nach Anspruch 3, mit Oszillatormitteln, die elektrisch mit der Varaktordiode gekoppelt und betreibbar sind, um gemäß dem abstimmbaren Resonanzkreis zu oszillieren, und mit einer Stcuerspannung, die mit einer Kathode der Varaktordiode elektrisch gekoppelt ist, wobei die Schwingungsfrequenz der Oszillatormittel wählbar ist, um korrespondierend zur ersten und zweiten Spannung jeweils in einem ersten Frequenzbereich und einem zweiten Frequenzbereich zu liegen.

5. Digitales Funktelefon nach Anspruch 4, bei dem die erste und zweite Spannung durch einen Schalter (S) ausgewählt werden, der einen mit der Anode der Varaktordiode (D) verbundenen Ausgang, einen mit der Masse der Schaltung verbundenen ersten Eingang (1) und einen mit der von der Anzeigensteuerung zur Verfügung gestellten negativen Spannung verbundenen anderen Eingang (2) aufweist.

6. Digitales Funktelefon nach Anspruch 5, bei dem der Schalter (S) eine Mehrzahl von Eingängen enthält, die mit jeweiligen negativen Spannungen verbunden sind.

7. Digitales Funktelefon nach irgendeinem der Ansprüche 4 bis 6, mit einem Frequenzsynthesizer, der einen spannungsgesteuerten Oszillator enthält, einen Phasenregelkreis und einen Phasenkomparator (22) mit einem mit seinem ersten Eingang gekoppelten Referenzfrequenzsignal (f_{ref}) und einer mit seinem zweiten Eingang gekoppelten Ausgangsfrequenz (f_{VCO}) vom VCO, wobei der Komparator ein Signal erzeugt, das mit der Phasendifferenz zwischen den mit dem ersten und zweiten Eingang gekoppelten Signalen vergleichbar ist, einem Tiefpass-Filter (23), das mit dem Ausgang des Phasenkomparators verbunden ist, um dessen Ausgangssignal in eine Steuergleichspannung (V_{cntr1}) zu filtern, und einem Frequenzteiler (25) mit einer durch ein Kanalsteuersignal steuerbaren Teilungszahl (N), um aus der Ausgangsfrequenz des VCO (f_{VCO}) ein geteiltes Signal zu erzeugen.

8. Digitales Funktelefon nach Anspruch 7, das geeignet ist, um die negative Spannung (-V_{b}) mit der Anode der Varaktordiode (D) zu verbinden, und zwar im wesentlichen gleichzeitig mit dem die Teilungszahl (N) des Frequenzteilers (25) ändernden Kanalsteuersignal, um einen großen Frequenzsprung zu erhalten.

9. Digitales Funktelefon nach Anspruch 8, bei dem der Frequenzsynthesizer mit Hilfe eines Prozessors zur Steuerung des Synthesizers angepaßt ist.

10. Digitales Funktelefon nach irgendeinem der Ansprüche 5 bis 6, bei dem die Oszillatormittel einen Transistor T enthalten.

## Revendications

1. Radiotéléphone numérique comprenant un circuit résonnant accordable destiné à un oscillateur commandé en tension (OCT), le circuit résonant accordable comprenant :
un capacité commandée en tension (D) couplée électriquement à une inductance (L1), dans laquelle
une borne de la capacité commandée en tension (D) peut être respectivement connectée électriquement d'une façon pouvant être sélectionnée à une première tension et à une seconde tension, l'une des tensions étant une tension négative fournie par un dispositif de commande d'affichage du radiotéléphone numérique.

2. Radiotéléphone numérique selon la revendication 1, dans lequel la première tension est la masse et la seconde tension est la tension négative (-V_{b}) fournie par le dispositif de commande d'affichage.

3. Radiotéléphone numérique selon la revendication 1 ou 2, dans lequel la capacité commandée en tension comprend une diode varicap dont l'anode peut être connectée électriquement en alternance aux première et seconde tensions.

4. Radiotéléphone numérique selon la revendication 3, comprenant en outre un moyen oscillateur couplé électriquement à la diode varicap et pouvant être mis en fonctionnement pour osciller en conformité avec le circuit résonant accordable, et une tension de commande couplée électriquement à une cathode de la diode varicap, la fréquence d'oscillation du moyen oscillateur pouvant être sélectionnée de façon à se situer dans une première gamme de fréquences et dans une seconde gamme de fréquences correspondant respectivement aux première et seconde tensions.

5. Radiotéléphone numérique selon la revendication 4, dans lequel les première et seconde tensions peuvent être sélectionnées par un commutateur (S) ayant une sortie connectée à l'anode de la diode varicap (D) et une première entrée (1) connectée à la masse du circuit et une autre entrée (2) connectée à une tension négative fournie par le dispositif de commande d'affichage.

6. Radiotéléphone numérique selon la revendication 5, dans lequel le commutateur (S) comprend une pluralité d'entrées connectées à des tensions négatives respectives.

7. Radiotéléphone numérique selon l'une quelconque des revendications 4 à 6, ayant un synthétiseur de fréquence comprenant un oscillateur commandé en tension, une boucle à verrouillage de phase et un comparateur de phase (22) ayant un signal de fréquence de référence (f_{ref}) provenant de l'OCT couplé à une seconde entrée, le comparateur produisant un signal pouvant être comparé à la différence de phase entre les signaux couplés aux première et seconde entrées, un filtre passe-bas (23) connecté à la sortie du comparateur de phase pour filtrer son signal de sortie afin de le transformer en tension continue de commande (V_{cntr1}), et un diviseur de fréquences (25) ayant un rapport de division (N) pouvant être commandé par un signal de commande de canal pour produire un signal divisé à partir de la fréquence de sortie de l'OCT (f_{OCT}).

8. Radiotéléphone numérique selon la revendication 7, adapté à connecter à l'anode de la diode varicap (D) la tension négative (-V_{b}) de façon sensiblement simultanée avec le fait que le signal de commande de canal change le rapport de division (N) du diviseur de fréquence (25) afin de produire un saut de fréquence important.

9. Radiotéléphone numérique selon la revendication 8, dans lequel le synthétiseur de fréquence est adapté au moyen d'un processeur pour commander le synthétiseur.

10. Radiotéléphone numérique selon l'une quelconque des revendications 5 à 6, dans lequel le moyen oscillateur comprend un transistor T.
